# EUROPEAN PATENT APPLICATION

(11) **EP 1 855 309 A1**
(43) Date of publication of application: **14.11.2007**
(21) Application number: 05805496.6
(22) Date of filing: 02.11.2005
(51) Int. Cl.: H01L 21/02, H01L 21/304, H01L 21/306, H01L 27/12

(54) **METHOD FOR MANUFACTURING BONDED WAFER AND BONDED WAFER**

(30) Priority: 28.02.2005 JP 2005054718
(71) Applicant: SHIN-ETSU HANDOTAI COMPANY LIMITED, Chiyoda-ku Tokyo 100-0005 (JP)
(72) Inventor: TAKEI, Tokio, c/o Nagano Denshi Co., Ltd., Chikuma-shi, Nagano 3878555 (JP); YOSHIZAWA, Sigeyuki, c/o Nagano Denshi Co., Ltd., Chikuma-shi, Nagano 3878555 (JP); MIYAZAKI, Susumu, c/o Nagano Denshi Co., Ltd., Chikuma-shi, Nagano 3878555 (JP); YOKOKAWA, Isao, c/o Yokonodaira Plant, Nakanoya, Anaka-shi, Gunma (JP); NOTO, Nobuhiko c/o Yokonodaira Plant, Nakanoya, Anaka-shi, Gunma (JP)
(74) Representative: Wibbelmann, Jobst
(86) International application number: PCT/JP2005/020202
(87) International publication number: WO 2006/092886

(57) **Abstract**

The present invention provides a method for manufacturing a bonded wafer prepared by bonding a base wafer and a bond wafer, comprising at least a step of etching an oxide film in a terrace region in an outer periphery of the bonded wafer wherein the oxide film in the terrace region is etched by spin-etching with holding and spinning the bonded wafer. Thereby, there is provided a method for manufacturing a bonded wafer in which an oxide film formed in a terrace region of a base wafer is efficiently etched without removing an oxide film on the back surface of the base wafer.

## Description

### Technical Field

The present invention relates to a method for manufacturing a bonded wafer and the bonded wafer, in particular to a method of etching an oxide film formed in a terrace region of the bonded wafer.

### Background Art

Bonded wafers are used as wafers for high performance devices. Each of the bonded wafers is manufactured by bonding a semiconductor wafer with another wafer or the like and then thinning the wafer on the side of fabricating elements.
Specifically, for example, two mirror-polished silicon wafers are prepared, and an oxide film is formed at least on one of the wafers. Then these wafers are bonded together and subjected to a heat treatment at a temperature of from 200 to 1200°C to increase bonding strength. After that, the wafer on the side of fabricating elements (a bond wafer) is ground, polished and the like to thin the wafer so that the bond wafer has a desired thickness. As a result, a bonded SOI wafer comprising an SOI (Silicon On Insulator) layer can be manufactured.

Examples of a method of thinning the bond wafer may include the method of grinding and polishing; and also a method (which is also referred to as Smart Cut (registered trademark)) in which an ion implanted layer is formed with hydrogen ions or the like in the bond wafer to be bonded, then the bond wafer and the base wafer are bonded together; and subsequently the bond wafer is delaminated at the ion implanted layer thereby thinning the bond wafer.

It should be noted that the bonded wafer can be manufactured with directly bonding silicon wafers together without interposing an oxide film therebetween. Furthermore, as the base wafer, an insulator wafer made of quartz, silicon carbide, alumina, or the like can be used.

When the bonded wafer is manufactured as mentioned above, each of two mirror-surface wafers to be bonded has a portion referred to as a polishing sag that has a slightly thinner thickness on the periphery and a chamfered portion. Such portions are not bonded or left as unbonded portions having weak bonding strengths. When the bond wafer is thinned by grinding or the like in the presence of such unbonded portions, the unbonded portions flake off in part in the thinning step. Therefore, the thinned bond wafer has a smaller diameter than the wafer to be a base (a base wafer). The bond wafer also has micro irregularities continuously formed in the periphery.
When such a bonded wafer is subjected to a device process, remained unbonded portions flake off in the device process. This causes particles and deteriorate device yield.

Consequently, there is proposed a method of removing the remained unbonded portions beforehand in which a masking tape is placed over the top surface of a thinned bond wafer, leaving open its periphery and then the bond wafer is etched (see Japanese Patent Application Laid-open (kokai) No. 03-250616). Such an outer peripheral region from which the unbonded portions are removed is referred to as a terrace region.

On the other hand, in the method of thinning by delamination at an ion implanted layer, unbonded portions in polishing sag portions become the terrace region after the delamination. As is the case with thinning by grinding and polishing, there are problems of generation of particles from the periphery of the thinned film or generation of cracks. Therefore, there is proposed a method of removing the periphery of the thinned film formed on the base wafer after the delamination (see International Publication WO01/027999).

However, the thinning by grinding and polishing has a problem such that the terrace region formed by removing the unbonded portions has residue of an oxide film formed by a heat treatment (bonding heat treatment) or the like for enhancing bonding strength, and the oxide film causes particle generation in a device fabrication process. In order to overcome the problem, a treatment of removing the oxide film in the terrace region is conducted. For example, the unbonded portions are removed, and then a bonded wafer is immersed in hydrofluoric acid to remove its oxide film. In this case, removed are oxide films not only in the front surface (including the terrace region) but also in the back surface of the bonded wafer.

By the way, in an SOI wafer in which an SOI layer is formed on a base wafer via an oxide film, the base wafer has a buried oxide film on one side but does not have an oxide film on the other side. Consequently, such an SOI wafer can warp. Then in order to prevent generation of warp, an oxide film can be formed also on the back surface of the SOI wafer. In this case, it is necessary to remove the oxide film on the front surface without removing the oxide film on the back surface.

In this way, when the oxide film on the front surface of an SOI wafer is removed while leaving the oxide film on the back surface as it is, the method taken is to immerse the SOI wafer in hydrofluoric acid with masking the back surface of the wafer with a masking tape, photoresist, or the like. However, such a method poses a problem of inefficiency because it takes time and is troublesome to place and remove a masking tape or to expose and strip off photoresist. In addition, the method also poses another problem of high cost because large amounts of an etchant are required.

In the case of using the method of conducting thinning by delamination at an ion implanted layer, forming an oxide film on a base wafer and conducting the bonding result in a terrace region having the oxide film after delamination. On the other hand, forming an oxide film only on a bond wafer and conducting the bonding result in a terrace region having no oxide film after delamination. However, when a heat treatment under an oxidizing atmosphere for increasing bonding strength is subsequently conducted, an oxide film is formed on the terrace region.

When epitaxial growth is conducted on the SOI layer of such an SOI wafer whose terrace region has an oxide film, polysilicon grows in the terrace region. This adversely affects crystallinity of the SOI layer or can generate particles.

By the way, a silicon oxide film to be a buried oxide film (BOX) of an SOI wafer can have a various thickness depending on the uses of devices to be fabricated. Typically, the thickness is in the range of 0.1 to 2 µm. However, for example, when the oxide film is used for specific applications such as an optical waveguide in optical integrated devices or the like, an extremely thick oxide film having a thickness equal to or more than 4 µm or equal to or more than 10 µm can be required. It is not practical to fabricate an SOI wafer having such an extremely thick buried oxide film by the method of conducting thinning by delamination at an ion implanted layer formed by implanting ions through the oxide film because extremely large ion implantation energy is required. Therefore, a method taken is to form a thick oxide film on the base wafer and conduct the bonding. In this case, the terrace region has the extremely thick oxide film after delamination, and which causes the above-mentioned problems.

### Disclosure of the Invention

The present invention has been accomplished in view of the aforementioned problems, and its object is to provide a method for manufacturing a bonded wafer in which an oxide film formed on a terrace region of a base wafer is efficiently etched without removing an oxide film on the back surface of the base wafer.

In order to achieve the aforementioned object, the present invention provides a method for manufacturing a bonded wafer prepared by bonding a base wafer and a bond wafer, comprising at least a step of etching an oxide film in a terrace region in an outer periphery of the bonded wafer wherein the oxide film in the terrace region is etched by spin-etching with holding and spinning the bonded wafer.

When the oxide film in the terrace region is etched by spin-etching with holding and spinning the bonded wafer as mentioned above, centrifugal force scatters an etchant outward, thereby preventing the etchant from reaching the back surface of the base wafer. Consequently, the oxide film formed in the terrace region is efficiently and uniformly etched without removing an oxide film on the back surface of the wafer. In addition, unlike conventional method, it is not necessary to protect the back surface of the wafer from the etchant with a masking tape or the like. As a result, the number of steps can be decreased, thereby increasing working efficiency.

In the above case, the bonded wafer having the oxide film in the terrace region to be etched can be manufactured by, at least, bringing the base wafer into close contact with the bond wafer; subjecting these wafers to a heat treatment under an oxidizing atmosphere to bond the wafers together; grinding and removing the outer periphery of the bond wafer so that the outer periphery has a given thickness; subsequently removing an unbonded portion of the outer periphery of the bond wafer by etching; and then thinning the bond wafer so that the bond wafer has a desired thickness, wherein the oxide film in the terrace region is etched by spin-etching after the etching of the unbonded portion or after the thinning of the bond wafer.

As mentioned above, the present invention can be applied to the instances where the bonded wafer having the oxide film in the terrace region to be etched is manufactured by, at least, bringing the base wafer into close contact with the bond wafer; subjecting these wafers to a heat treatment under an oxidizing atmosphere to bond the wafers together; grinding and removing the outer periphery of the bond wafer so that the outer periphery has a given thickness; subsequently removing an unbonded portion of the outer periphery of the bond wafer by etching; and then thinning the bond wafer so that the bond wafer has a desired thickness, wherein the oxide film in the terrace region is etched by spin-etching after the etching of the unbonded portion or after the thinning of the bond wafer.

Alternatively, the bonded wafer having the oxide film in the terrace region to be etched can be manufactured by, at least, implanting ions into the bond wafer; bringing the bond wafer into close contact with the base wafer; and then delaminating the bond wafer at an ion implanted layer for thinning the bond wafer.

As mentioned above, the present invention can also be applied to the instances where the bonded wafer having the oxide film in the terrace region to be etched is manufactured by, at least, implanting ions into the bond wafer; bringing the bond wafer into close contact with the base wafer; and then delaminating the bond wafer at an ion implanted layer for thinning the bond wafer.

In the above cases, an aqueous solution of HF is preferably used as an etchant for the spin-etching.

In this way, the oxide film can be etched efficiently by using an aqueous solution of HF.

In the above case, a 50% aqueous solution of HF is preferably used as the aqueous solution of HF.

In this way, use of a 50% aqueous solution of HF as the etchant for the spin-etching makes it possible to conduct fast etching, thereby increasing working efficiency.

In the above cases, the spin-etching is preferably conducted by providing the etchant directly to the terrace region.

In this way, when the spin-etching is conducted by providing the etchant directly to the terrace region, the etchant does not flow on the central portion of the bonded wafer (for example, the surface of the SOI layer). Consequently, even when the SOI layer has micro defects, there is less possibility that the etchant erodes the BOX through the micro defects in the SOI layer.

In the above case, the spin-etching is preferably conducted with providing a fluid to a central portion of the bonded wafer so that the fluid protects the central portion from the etchant.

In this way, when the spin-etching is conducted with providing a fluid to a central portion of the bonded wafer so that the fluid protects the central portion from the etchant, the etchant does not flow on the central portion of the bonded wafer (for example, the surface of the SOI layer). Consequently, even when the SOI layer has micro defects, there is much less possibility that the etchant erodes the BOX through the micro defects in the SOI layer.

In this case, the fluid can be any one of water, air, nitrogen gas, and inert gas.

In this way, the fluid protecting the central portion of the bonded wafer from the etchant can be any one of water, air, nitrogen gas, and inert gas.

In the above cases, time for conducting the spin-etching and/or concentration of the etchant can be adjusted to control a thickness to be left of the oxide film formed in the terrace region of the base wafer.

In this way, a thickness to be left of the oxide film in the terrace region can be controlled arbitrarily by adjusting time for conducting the spin-etching and/or concentration of the etchant.

The base wafer and the bond wafer to be bonded are preferably silicon single crystal wafers at least one of which has an oxide film.

As mentioned above, the method according to the present invention can be applied to manufacturing of a bonded SOI wafer in which a base wafer and a bond wafer, both of which are silicon single crystal wafers, are bonded together via an insulator film of an oxide film.

It is preferable that the bond wafer is thinned and an oxide film is formed on a surface of the bond wafer before the spin-etching is conducted.

As a result of this, erosion of the BOX can be certainly prevented even when the etchant reaches the surface of the bond wafer.

Furthermore, ozone water is preferably provided to the terrace region after the spin-etching is conducted.

This imparts hydrophilicity to the terrace region after the oxide film is removed, thereby preventing adhesion of particles.

In addition, an SOI wafer can be manufactured as the bonded wafer.

As mentioned above, the present invention can be applied to the manufacturing of SOI wafers.

In this case, the SOI wafer can be manufactured so that its SOI layer has a thickness equal to or less than 0.5 µm.

Use of the present invention effectively protects the BOX when the SOI wafer has an SOI layer with a thickness equal to or less than 0.5 µm.

In the above cases, after the SOI wafer is manufactured, an epitaxial layer of Si or SiGe can be formed on a surface of the SOI layer of the SOI wafer.

When the epitaxial layer of Si or SiGe is formed on such an SOI wafer in which an oxide film in a terrace region is removed, formation of polysilicon can be prevented. Consequently, crystallinity of the SOI layer is not adversely affected and generation of particles can be prevented.

The present invention also provides the bonded wafer manufactured by the above methods for manufacturing a bonded wafer.

Such a bonded wafer is of high quality because an oxide film in a terrace region of the base wafer is uniformly etched without removing an oxide film on the back surface of the base wafer; the oxide film in the terrace region does not generate particles in device fabrication processes; and warp of the wafer is reduced. In particular, a bonded wafer can be provided in which a thickness to be left of the oxide film in the terrace region is precisely controlled.

As described above, according to the present invention, the oxide film formed in the terrace region of the base wafer is etched by spin-etching with holding the bonded wafer. As a result of this, the oxide film in the terrace region can be uniformly etched without removing an oxide film on the back surface of the base wafer even in instances where the oxide film on the back surface of the base wafer is not particularly protected with a masking tape or the like. As a result, etching of an oxide film in a terrace region on one side of the wafer can be conducted efficiently in less number of steps than the conventional methods.

### Brief Explanation of the Drawings

Fig. 1 is a schematic view of an embodiment of the method for manufacturing a bonded wafer according to the present invention.
Fig. 2 is a single-wafer-processing spin-etching apparatus that can be used in the method for manufacturing a bonded wafer according to the present invention.
Fig. 3 is a cross-sectional view schematically explaining a configuration of an oxide film in a terrace region in a front surface of a bonded wafer.
Fig. 4 shows photographs showing left thickness in each area of an oxide film in a terrace region in each time for conducting the spin-etching.
Fig. 5 is a schematic view of another embodiment of the method for manufacturing a bonded wafer according to the present invention.
Fig. 6 is a single-wafer-processing spin-etching apparatus that can be used in the method for manufacturing a bonded wafer according to the present invention.

### Best Mode for Carrying out the Invention

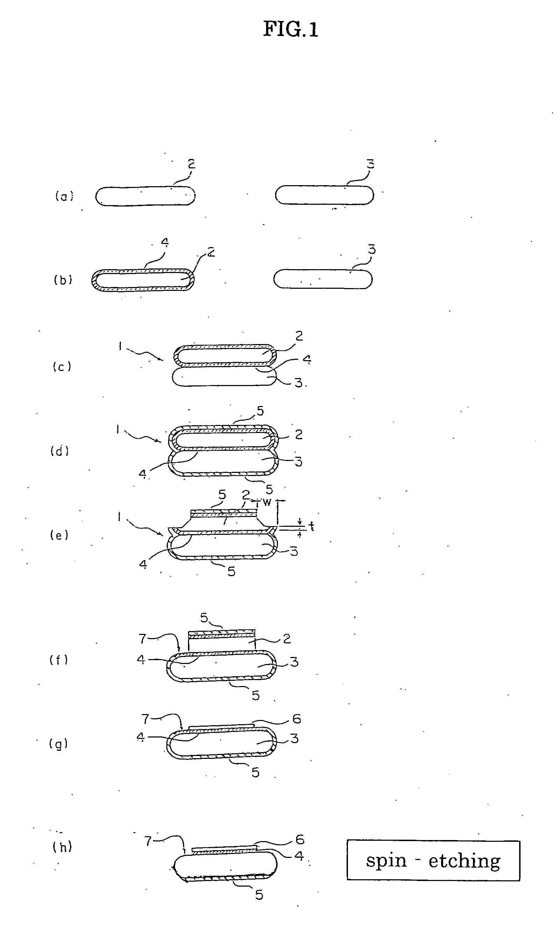

Hereinafter, the present invention will be explained further in detail. However, the present invention is not limited thereto.
Turning now to Fig. 1, this shows a schematic view of an embodiment of the method for manufacturing a bonded wafer according to the present invention.

In Fig. 1, a bond wafer 2 and a base wafer 3 are prepared (Fig. 1(a)). The wafers are material wafers for fabricating an SOI wafer by bonding the wafers together. The bond wafer and the base wafer are not particularly restricted. For example, the wafers may be silicon single crystal wafers.
Next, among the prepared silicon single crystal wafers, the bond wafer 2 is subjected to a heat treatment to form an oxide film 4 on the surface of the bond wafer (Fig. 1(b)).

Then the bond wafer 2 having the oxide film is brought into close contact with the base wafer 3 under a clean atmosphere (Fig. 1(c)). These wafers are subjected to a heat treatment under an oxidizing atmosphere to bond firmly the bond wafer 2 and the base wafer 3 together. Thus a bonded wafer 1 is obtained. The heat treatment may be conducted, for example, under conditions of an atmosphere containing oxygen or water vapor and a temperature in the range of 200°C to 1200°C (Fig. 1(d)). As a result of the heat treatment, the bond wafer 2 and the base wafer 3 are bonded firmly together, and an oxide film (a bonding oxide film) 5 is formed on the whole outer surfaces of the bonded wafer 1.

The bonded wafer 1 thus bonded has portions where the bond wafer 2 and the base wafer 3 are not bonded in the region about 2mm from the outer periphery. Such unbonded portions cannot be used as an SOI layer on which devices are fabricated. Furthermore, the unbonded portions flake off in subsequent processes and causes various problems. Therefore, the unbonded portions must be removed.

In order to remove the unbonded portions, as shown in Fig. 1(e), the outer periphery where the unbonded portions exist of the bond wafer 2 is firstly ground and removed so that the outer periphery has a given thickness t. Grinding is used because fast removing is possible and processing accuracy is good.
In the above case, the given thickness t may be 20 to 150 µm.

Next, etching is conducted to provide a wafer shown in Fig. 1(f) in which the unbonded portions of the outer periphery of the bond wafer 2 are removed. This is readily conducted by immersing the bonded wafer 1 into an etchant exhibiting much faster etching rate to a silicon single crystal than to an oxide film. More specifically, the etchant etches the outer periphery of the bond wafer 2 because silicon is exposed by the grinding whereas the etchant does not etch other portions of the bonded wafer because these portions are covered with the oxide film 5. Such etching may be so-called alkali etching using KOH, NaOH, or the like.
By conducting such an etching, a terrace region 7 is formed.

Then as shown in Fig. 1(g), the surface of the bond wafer 2 is thinned so that the bond wafer has a desired thickness. Measures of thinning the bond wafer are not particularly restricted, and grinding and polishing can be conducted according to standard procedures.

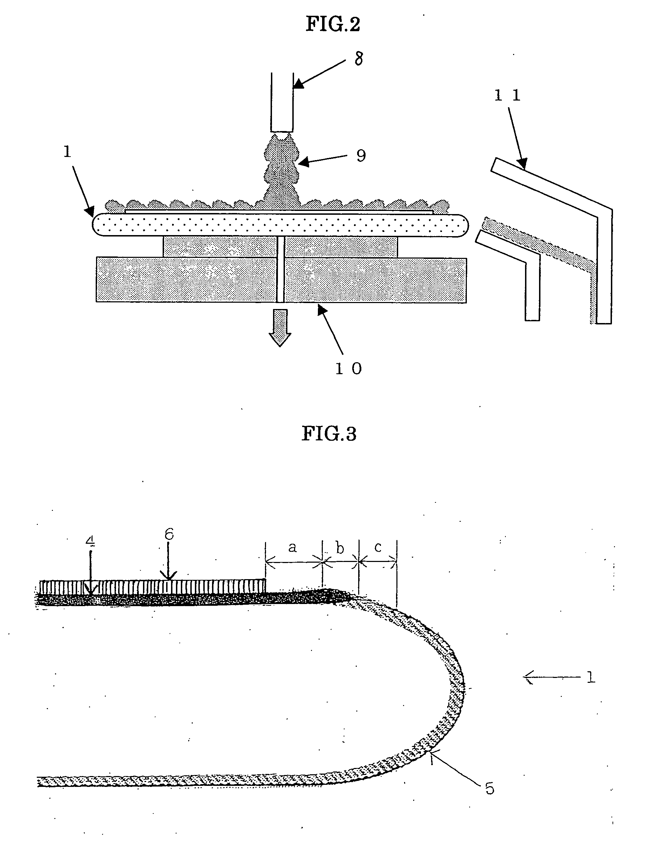

Subsequently, spin-etching is conducted for etching the oxide film in the terrace region 7 of the base wafer 3. Means for holding the wafer during the spin-etching is not particularly restricted. For example, the wafer can be held by sucking the base-wafer-3 side. An apparatus for conducting the spin-etching is also not particularly restricted. For example, an apparatus shown in Fig. 2 may be used. Etching is conducted as follows: the bonded wafer 1 is held by sucking with a wafer holding means 10; an etchant 9 is provided from a nozzle 8; and the bonded wafer 1 is spun at high rotational speed. In this way, the wafer is etched with rotating the wafer, whereby centrifugal force scatters the etchant 9 outward of the wafer. The scattered etchant 9 is recovered via a recovery cup 11 and does not reach the back surface of the wafer. Therefore, even when the back surface of the wafer is not particularly masked with a masking tape, photoresist, or the like, the oxide film on the back surface side of the wafer is left unremoved. Therefore, according to the present invention, the step of masking the back surface of the wafer with a masking tape or the like becomes unnecessary. As a result, the number of steps can be decreased, and etching of an oxide film in a terrace region in one surface of the wafer can be conducted more efficiently.

As mentioned above, the etchant does not reach the back surface of the wafer. Therefore, sucking and holding only a part of the back surface of the wafer during the spin-etching is sufficient because the oxide film on the back surface of the wafer is not etched. Alternatively, sucking the whole of the back surface of the wafer or sucking so that regions where the oxide film is intended to be left are covered is definitely possible.

The etchant used for the spin-etching is not particularly restricted as long as the etchant is capable of etching an oxide film. A preferred etchant is an aqueous solution of HF. In this case, a 50% aqueous solution of HF is more preferably used. The 50% aqueous solution of HF has a high etching rate, thereby further increasing working efficiency. In this way, etchants having relatively high concentrations can be used in spin-etching. Therefore, even when a thick oxide film is formed in the terrace region, the film can be etched off rapidly and uniformly.

Sometimes demanded are bonded wafers in which oxide films formed in terrace regions of base wafers are not completely removed and are left to have a given thickness. In this case, time for conducting the spin-etching and/or concentration of the etchant is adjusted to control precisely a thickness to be left of the oxide film formed in the terrace region. When the conventional method of immersing the whole wafer into an etchant is used, it is possible to remove the whole oxide film, however, it is difficult to control the oxide film to have a given thickness precisely. On the other hand, use of the present invention makes it possible easily to control the oxide film to have a given thickness. In this case, controlling of the temperature of an etchant makes it possible to control an etching rate more precisely.

By the manner mentioned above, a bonded wafer (Fig. 1(h)) according to the present invention can be manufactured. The bonded wafer has an SOI layer 6 and the oxide film 5 on the base wafer side while an oxide film in the terrace region 7 is removed.

In the method mentioned above, the surface of the bond wafer 2 is thinned and then the spin-etching is conducted. However, the present invention is not restricted thereto. It is also possible to etch the unbonded portions, subsequently to conduct the spin-etching, and then to thin the bond wafer.

In the method mentioned above, the oxide film 4 is formed on the bond wafer 2, and then the bond wafer 2 is brought into close contact with the base wafer 3. Alternatively, an oxide film is formed on the base wafer 3 and then the base wafer 3 is brought into close contact with the bond wafer 2; or oxide films are formed on both the bond wafer 2 and the base wafer 3 and then the wafers are brought into close contact with each other. Furthermore, it is also possible to bring the bond wafer into close contact directly with the base wafer without interposing an oxide film therebetween. The base wafer and the bond wafer that are used in the present invention are not restricted to silicon single crystal wafers.

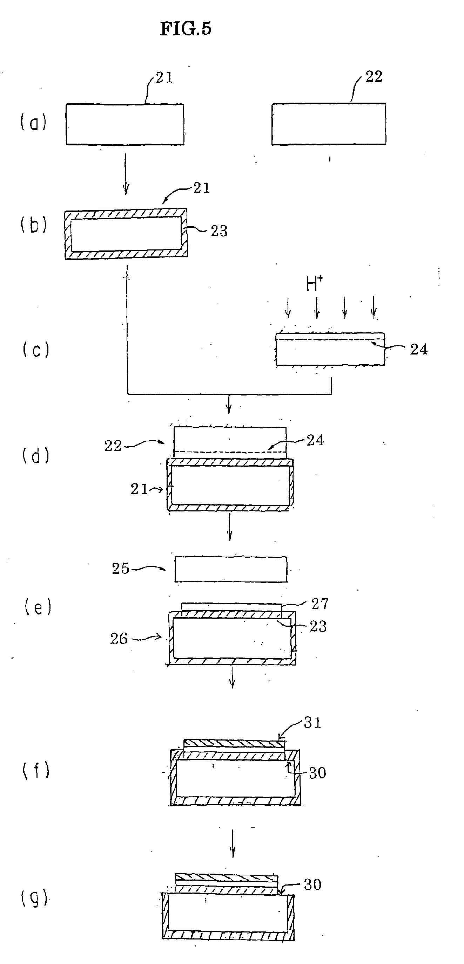

Turning now to Fig. 5, as another embodiment of the present invention, the case of manufacturing an SOI wafer according to hydrogen ion delamination method (Smart Cut method (registered trademark)) is explained.

First, in a step (a) in Fig.5, two silicon mirror surface wafers are prepared. More specifically, prepared are a base wafer 21 to be a base and a bond wafer 22 to be an SOI layer that meet requirements for devices.

Next, in a step (b), at least one of the wafers, the base wafer 21 in this explanation, is subjected to thermal oxidation to form an oxide film 23 having a thickness of about 0.1 µm to 2.0 µm on the wafer surface. In some uses, an oxide film having a thickness equal to or more than 4.0 µm is formed.

In a step (c), at least either hydrogen ions or rare gas ions, hydrogen ions in this explanation, are implanted to one surface of the bond wafer 22 to form a microbubble layer (an enclosed layer) 24 parallel to the surface at an average penetration depth of the ions. Preferred implantation temperatures are 25 to 450°C.

In a step (d), the base wafer 21 is stacked via an oxide film on the hydrogen-ion-implanted surface of the bond wafer 22 to which hydrogen ions are implanted. By bringing the surfaces of the two wafers into contact with each other in a clean atmosphere at room temperature, the wafers are boned together without using adhesives.

Next, in a step (e), the wafers are delaminated at the enclosed layer 24 as a boundary, thereby separating the wafers into a delaminated wafer 25 and an SOI wafer 26 in which an SOI layer 27 is formed on the base wafer 21 via an oxide film 23. For example, a heat treatment is conducted under an inert gas atmosphere at a temperature about 500°C or more, thereby permitting the separation into a delaminated wafer 25 and an SOI wafer 26 (SOI layer 27 + oxide film 23 + base wafer 21) due to crystal rearrangement and agglomeration of bubbles.
It should be noted that when each surface of the wafers to be bonded are subjected to a plasma treatment to increase bonding strength, mechanical delamination at the enclosed layer 24 is alternatively possible without conducting the heat treatment after bringing the wafers into contact with each other.

The bonding strength between the wafers bonded through the bonding step (d) and the delamination step (e) is weak for being used in device fabrication processes. Therefore, the SOI wafer 26 is subjected to a high temperature heat treatment as a bonding heat treatment to obtain sufficiently high bonding strength. For example, this heat treatment is preferably conducted under an inert gas atmosphere or an oxidizing gas atmosphere (under an oxidizing gas atmosphere in this explanation) in temperatures from 1050°C to 1200°C in the range of 30 minutes to 2 hours.

By conducting such a bonding heat treatment step (f), an oxide film 31 is formed on the surface of the SOI layer 27, and the oxide films on the back surface of the base wafer and in the terrace region are also thickened.

After the bonding heat treatment step (f) is conducted as mentioned above, the oxide film in the terrace region 30 is removed in an spin-etching step (g).

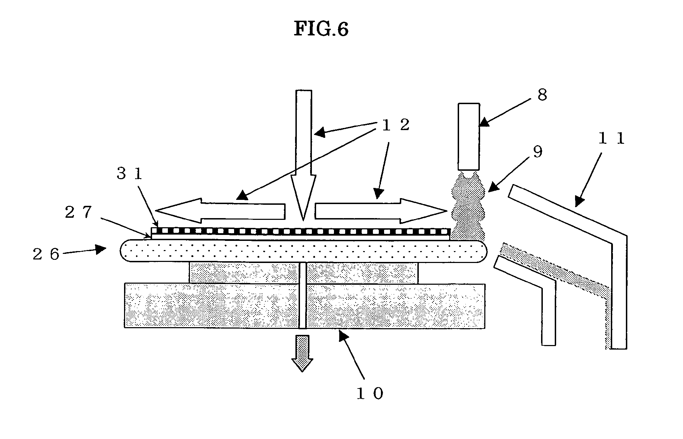

An apparatus for conducting spin-etching is not particularly restricted and the apparatus mentioned above may be used. As an alternative example, an apparatus shown in Fig. 6 may be used. The spin-etching is conducted as follows: the SOI wafer 26 is spun at high rotational speed while the SOI wafer 26 is held by sucking with a wafer holding means 10; and an etchant 9 is provided directly to the terrace region from a nozzle 8, and a fluid 12 is provided to the central portion of the SOI wafer so that the fluid protects the central portion from the etchant 9.

In this way, when the spin-etching is conducted by providing the etchant directly to the terrace region, the etchant does not flow on the surface of the SOI layer. Therefore, even when the SOI layer has a thickness of 0.5 µm or less, there is less possibility that the etchant erodes the BOX through the micro defects in the SOI layer. Furthermore, when the spin-etching is conducted by providing the fluid 12 to the central portion of the bonded wafer so that the fluid protects the central portion from the etchant, there is still less possibility that the etchant does not flow on the surface of the SOI layer. Therefore, even when the SOI layer has a thickness of 0.5 µm or less, there is still less possibility that the etchant erodes the BOX through the micro defects in the SOI layer. The fluid 12 is not particularly restricted. For example, the fluid can be any one of water, air, nitrogen gas, and inert gas.

Furthermore, thinning the bond wafer and forming the oxide film 31 on the surface of the bond wafer (the surface of the SOI layer 27) as shown in Fig. 6 before conducting the spin-etching step (g) can surely prevent erosion of the BOX even when the etchant 9 reaches the surface of the SOI layer 27.

The wafer is etched with rotating the wafer by spin-etching, whereby centrifugal force scatters the etchant 9 outward of the wafer. The scattered etchant 9 is recovered via a recovery cup 11 and does not reach the back surface of the wafer. Therefore, even when the back surface of the wafer is not particularly masked with a masking tape, photoresist, or the like, the oxide film on the back surface side is left unetched. Therefore, according to the present invention, the step of masking the back surface of the wafer with a masking tape or the like becomes unnecessary. As a result, the number of steps can be decreased, and etching of an oxide film in a terrace region in one surface of a wafer can be conducted more efficiently.

In addition, after the spin-etching is conducted as mentioned above, ozone water can be provided to the terrace region 30. This imparts hydrophilicity to the terrace region, in which the oxide film is removed, thereby preventing adhesion of particles.

By conducting the steps (a) to (g), an SOI wafer with no oxide film in its terrace region can be manufactured.
In the above method, an oxide film is formed on the base wafer and then the base wafer is brought into intimate contact with the bond wafer. Alternatively, an oxide film is formed on the bond wafer and then the bond wafer is brought into intimate contact with the base wafer; or oxide films may be formed on both the base wafer and the bond wafer.

In addition, after an SOI wafer is manufactured as mentioned above, an epitaxial layer of Si or SiGe may be formed on the surface of the SOI layer of the SOI wafer. The SOI wafer in which an oxide film in its terrace region is removed does not have an exposed oxide film. Therefore, when an epitaxial layer of Si or SiGe is formed, formation of polysilicon can be prevented. As a result, crystallinity of the SOI layer is not adversely affected and generation of particles can be prevented.

As mentioned above, use of the method for manufacturing a bonded wafer according to the present invention makes it possible to manufacture high-quality SOI wafers each having an SOI layer with a thickness equal to or less than 0.5 µm because there is less possibility that an etchant erodes a BOX through micro defects in the SOI layer during spin-etching even when the SOI layer has a thin thickness equal to or less than 0.5 µm.

The bonded wafer obtained by the manufacturing methods mentioned above is a wafer in which an oxide film formed in a terrace region of the base wafer is etched without removing an oxide film on the back surface of the base wafer. Therefore, the oxide film in the terrace region does not generate particles in device fabrication processes and warp of the wafer is reduced. Thus a high-quality bonded wafer can be obtained. Alternatively, a bonded wafer having an oxide film with a precisely controlled desired thickness in the terrace region can also be manufactured.

### EXAMPLES

Hereinafter, Examples of the present invention will be explained. However, the present invention is not restricted thereto.

### (Example 1)

First, mirror-polished CZ wafers each having a diameter of 200 mm, conductivity type: p-type, and a resistivity of 4 to 6 Ω·cm were prepared. These wafers were used as a base wafer and a bond wafer.
These wafers were brought into close contact with each other according to the steps (a) to (c) in Fig. 1. Then the wafers were subjected to a bonding heat treatment at 1150°C under an oxidizing atmosphere for 3 hours to prepare a bonded wafer 1 in Fig. 1(d).

Next, as shown in Fig. 1(e), the outer periphery of the bond wafer 2 was ground with a grinding machine from the outer periphery toward the center of the wafer. The thickness t was 50 µm.
Then unbonded portions in the outer periphery of the bond wafer 2 were removed by etching. An etchant used in the etching was NaOH. The whole wafers were immersed in NaOH to conduct the etching. Etching removal was 90 µm. Thus a wafer shown in Fig. 1(f) was obtained.

Subsequently, the surface of the bond wafer 2 was thinned by grinding and polishing with a surface grinding machine and a single-side polishing machine to form an SOI layer 6. Thus a wafer shown in Fig. 1(g) was obtained.
The configuration of the oxide film in the terrace region on the front surface of the bonded wafer at this time is shown in Fig. 3. The oxide film in the region a consists of the oxide film (buried oxide film) 4 of the bond wafer 2. The oxide film in the region b consists of the buried oxide film 4 as well as the oxide film (bonding oxide film) 5 generated by the heat treatment for bonding the bond wafer and the base wafer. The oxide film in the region b is thicker as a whole than the oxide film in the region a. The oxide film in the region c consists of the bonding oxide film 5.

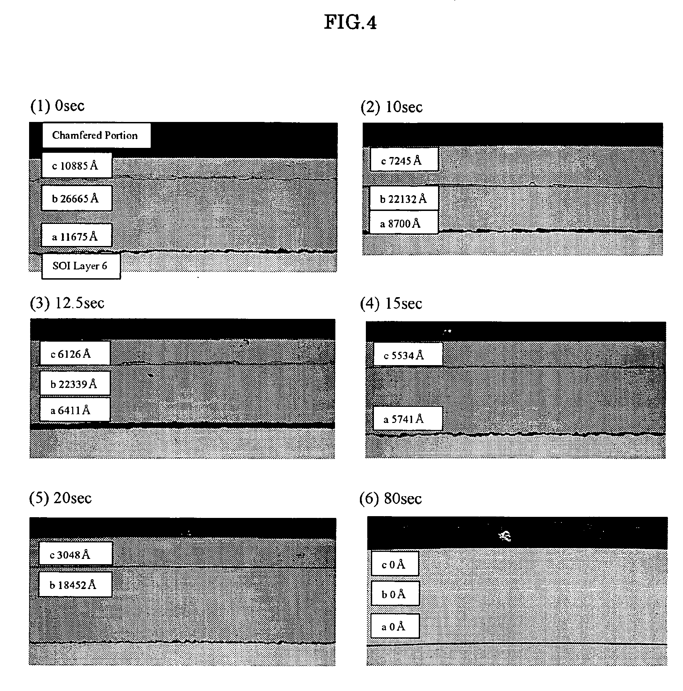

Spin-etching was conducted while the bonded wafer was held by sucking its base-wafer side. A 50% aqueous solution of HF was used as an etchant. Time for etching was 0 to 80 seconds. Thicknesses of oxide films in the regions a to c were measured at established periods. Obtained results are shown in Fig. 4. Fig.4 shows photographs in which the terrace regions of the wafer were taken. Each of the photographs shows a thickness of an oxide film in each region from an SOI layer shown at the bottom of the photograph to a chamfered region shown at the top of the photograph.

As is evident from the results, it has been established that an oxide film formed on a terrace region in a base wafer can be entirely removed by conducting spin-etching for 80 seconds while the bonded wafer is held by sucking the base-wafer side of the bonded wafer. It has also been established that a thickness to be left of the oxide film formed in the terrace region of the base wafer can be controlled by changing time for conducting the spin-etching, thereby permitting manufacturing of bonded wafers each having an oxide film with an arbitrary desired thickness in the terrace region.

### (Example 2)

First, mirror-polished CZ wafers each having a diameter of 200 mm, conductivity type: p-type, and a resistivity of 4 to 6 Ω·cm were prepared. These wafers were used as a base wafer and a bond wafer. As shown in Fig. 5, a 5 µm thick oxide film was formed on the base wafer, and an Si layer of the bond wafer was transferred to the base wafer by Smart Cut method (registered trademark) to obtain an SOI wafer. After that, a stabilizing heat treatment was conducted.

The SOI wafer has the 5 µm thick oxide film in its terrace region. This oxide film was removed by spin-etching with an apparatus shown in Fig. 6. A 50% aqueous solution of HF was used as an etchant. The etchant was provided directly to the terrace region for 5 minutes to remove the oxide film in the terrace region. During the spin-etching, pure water was provided to the central portion of the SOI wafer as a fluid 12 for protecting the SOI layer from the etchant. After that, the wafer was rinsed for 2 minutes to remove the aqueous solution of HF. After the rinse treatment, spin-drying was conducted.

Then the oxide film 31 on the SOI layer was removed. The surface of the SOI layer was polished and planarized. Thus an SOI wafer was obtained.

Thus obtained SOI wafer has been confirmed to be of extremely high quality because HF does not erode the BOX through micro defects in an SOI layer during spin-etching.

### (Example 3)

First, mirror-polished CZ wafers each having a diameter of 200 mm, conductivity type: p-type, and a resistivity of 4 to 6 Ω·cm were prepared. These wafers were used as a base wafer and a bond wafer. As shown in Fig. 5, a 400 nm thick oxide film was formed on the base wafer, a Si layer of the bond wafer was transferred to the base wafer by Smart Cut method (registered trademark) to obtain an SOI wafer. After that, a stabilizing heat treatment was conducted.

The SOI wafer has the 400 nm thick oxide film in its terrace region. This oxide film was removed by spin-etching with an apparatus shown in Fig. 6. A 50% aqueous solution of HF was used as an etchant. The etchant was provided directly to the terrace region for a minute to remove the oxide film in the terrace region. During the spin-etching, pure water was provided to the central portion of the SOI wafer as a fluid 12 for protecting the SOI layer from the etchant. After that, the wafer was rinsed for 30 seconds to remove the aqueous solution of HF. After the rinse treatment, spin-drying was conducted.

Then the oxide film 31 on the SOI layer was removed. The surface of the SOI layer was polished and planarized. Thus an SOI wafer with a 200 nm thick SOI layer and a 400 nm BOX layer was obtained.
After that, a Si epitaxial growth was conducted to obtain an SOI wafer having an SOI layer with an ultimate thickness of 1000 nm.

Thus obtained SOI wafer has been confirmed to be of extremely high quality and to have a thick SOI layer because HF does not erode the BOX through micro defects in the SOI layer during spin-etching, and poly Si is not generated in the terrace region due to conducting the epitaxial growth after the oxide film is removed from the terrace region.

It should be noted that the present invention is not limited to the embodiments described above. The above-described embodiments are mere examples, and those having substantially the same structure as technical ideas described in the appended claims and providing the similar functions and advantages are included in the scope of the present invention.

In the above embodiments, the thinning of the bond layer was conducted by grinding and polishing or ion implantation delamination method. Alternatively, the thinning may be conducted by another method such as etching.

## Claims

1. A method for manufacturing a bonded wafer prepared by bonding a base wafer and a bond wafer, comprising at least a step of etching an oxide film in a terrace region in an outer periphery of the bonded wafer wherein the oxide film in the terrace region is etched by spin-etching with holding and spinning the bonded wafer.

2. The method for manufacturing a bonded wafer according to Claim 1, wherein the bonded wafer having the oxide film in the terrace region to be etched is manufactured by, at least, bringing the base wafer into close contact with the bond wafer; subjecting these wafers to a heat treatment under an oxidizing atmosphere to bond the wafers together; grinding and removing the outer periphery of the bond wafer so that the outer periphery has a given thickness; subsequently removing an unbonded portion of the outer periphery of the bond wafer by etching; and then thinning the bond wafer so that the bond wafer has a desired thickness, wherein the oxide film in the terrace region is etched by spin-etching after the etching of the unbonded portion or after the thinning of the bond wafer.

3. The method for manufacturing a bonded wafer according to Claim 1, wherein the bonded wafer having the oxide film in the terrace region to be etched is manufactured by, at least, implanting ions into the bond wafer; bringing the bond wafer into close contact with the base wafer; and then delaminating the bond wafer at an ion implanted layer for thinning the bond wafer.

4. The method for manufacturing a bonded wafer according to any one of Claims 1 to 3, wherein an aqueous solution of HF is used as an etchant for the spin-etching.

5. The method for manufacturing a bonded wafer according to Claim 4, wherein a 50% aqueous solution of HF is used as the aqueous solution of HF.

6. The method for manufacturing a bonded wafer according to any one of Claims 1 to 5, wherein the spin-etching is conducted by providing the etchant directly to the terrace region.

7. The method for manufacturing a bonded wafer according to Claim 6, wherein the spin-etching is conducted with providing a fluid to a central portion of the bonded wafer so that the fluid protects the central portion from the etchant.

8. The method for manufacturing a bonded wafer according to Claim 7, wherein the fluid is any one of water, air, nitrogen gas, and inert gas.

9. The method for manufacturing a bonded wafer according to any one of Claims 1 to 8, wherein time for conducting the spin-etching and/or concentration of the etchant is adjusted to control a thickness to be left of the oxide film formed in the terrace region of the base wafer.

10. The method for manufacturing a bonded wafer according to any one of Claims 1 to 9, wherein the base wafer and the bond wafer to be bonded are silicon single crystal wafers at least one of which has an oxide film.

11. The method for manufacturing a bonded wafer according to any one of Claims 1 to 10, wherein the bond wafer is thinned and an oxide film is formed on a surface of the bond wafer before the spin-etching is conducted.

12. The method for manufacturing a bonded wafer according to any one of Claims 1 to 11, wherein ozone water is provided to the terrace region after the spin-etching is conducted.

13. The method for manufacturing a bonded wafer according to any one of Claims 1 to 12, wherein an SOI wafer is manufactured as the bonded wafer.

14. The method for manufacturing a bonded wafer according to Claim 13, wherein the SOI wafer is manufactured so that its SOI layer has a thickness equal to or less than 0.5 µm.

15. The method for manufacturing a bonded wafer according to Claim 13 or Claim 14, wherein after the SOI wafer is manufactured, an epitaxial layer of Si or SiGe is formed on a surface of the SOI layer of the SOI wafer.

16. The bonded wafer manufactured by the method for manufacturing a bonded wafer according to any one of Claims 1 to 15.
